# FASCICULE DE BREVET EUROPEEN

(11) **EP 0 883 862 B1**
(45) Date de publication et mention de la délivrance du brevet: **03.05.2000**
(21) Numéro de dépôt: 97906242.9
(22) Date de dépôt: 21.02.1997
(51) Int. Cl.: G06K 19/077

(54) **CARTE A CIRCUIT INTEGRE COMPORTANT DES PISTES CONDUCTRICES EN POLYMERE CONDUCTEUR**
LEITERBAHNEN AUS LEITFÄHIGEM POLYMER UMFASSENDE IC-KARTE
INTEGRATED CIRCUIT CARD COMPRISING A CONDUCTOR PATTERN MADE OF A CONDUCTIVE POLYMER

(30) Priorité: 28.02.1996 FR 9602456
(43) Date de publication de la demande: 16.12.1998
(73) Titulaire: SCHLUMBERGER Systèmes, 92120 Montrouge (FR)
(72) Inventeur: AUDOUX, Jean-Noel,, F-45100 Orléans (FR)
(74) Mandataire: Fruchard, Guy
(86) Numéro de dépôt international: FR9700325
(87) Numéro de publication internationale: WO9732279

(56) Documents cités:
- EP-A- 0 343 030
- FR-A- 2 629 666
- US-A- 5 493 969

## Description

La présente invention concerne une carte à circuit intégré comportant des pistes conductrices en polymère conducteur.

Les cartes à circuit intégré comportant des pistes conductrices en polymère conducteur sont maintenant bien connues. Selon un procédé connu, une telle carte est réalisée en effectuant successivement les étapes de placer un circuit intégré sur une carte en matière plastique, enfoncer le circuit intégré au moyen d'un poinçon chauffant de façon que la face supérieure du circuit intégré affleure la surface supérieure de la carte, puis déposer par sérigraphie un polymère conducteur formant des plages conductrices et des pistes conductrices reliant les plages conductrices aux plots du circuit intégré.

Par ailleurs on sait que pour déposer un polymère conducteur par sérigraphie on utilise un écran qui est rendu étanche aux liquides à l'exception de lignes de réserve qui sont perméables aux liquides et qui sont dessinées selon un contour correspondant aux pistes conductrices que l'on souhaite réaliser. Pour réaliser des pistes conductrices, l'écran est placé au-dessus de la carte en matière plastique, du polymère conducteur à l'état liquide est déposé sur l'écran et une râcle est déplacée sur l'écran pour amener le polymère conducteur à l'état liquide dans les lignes de réserve et retirer le surplus de polymère conducteur. La râcle est déplacée selon une direction qui sera par la suite appelée direction de référence et est généralement disposée perpendiculairement à cette direction.

On a constaté que lors de la réalisation de pistes conductrices en polymère conducteur par sérigraphie les pistes conductrices obtenues étaient souvent défectueuses par suite d'un court-circuit entre deux pistes conductrices adjacentes. Une analyse microscopique a permis de constater que ces court-circuits résultaient de bavures réalisées par du polymère conducteur s'infiltrant sous l'écran et débordant d'une ligne de réserve pour atteindre la piste conductrice adjacente.

Pour éviter ce problème on a proposé dans le document US-A-5 493 969 de déplacer la raclette selon une direction différente de 90° par rapport à une direction de la piste afin que le polymère conducteur ait tendance à s'écouler selon le bord de la ligne de réserve de l'écran de sérigraphie plutôt que de déborder de cette ligne. Toutefois les pistes conductrices présentent des contours anguleux de sorte que les angles constituent des zones d'accumulation du polymère conducteur, ce qui est propice à la formation d'une tache conductrice réalisant un court-circuit entre deux lignes conductrices adjacentes.

Selon l'invention, on réalise des pistes conductrices ayant un contour curviligne. On a constaté que l'on obtenait ainsi des bavures présentant une amplitude minimale pour des pistes conductrices présentant un contour sinueux quelle que soit la direction de déplacement de la râcle.

Lorsque, pour des raisons d'encombrement il est nécessaire de réaliser un segment de piste sensiblement perpendiculaire à la direction de référence, on prévoit avantageusement selon l'invention un tronçon de dégagement prolongeant le segment de piste selon une direction sensiblement identique à la direction de référence. Le polymère conducteur à l'état liquide se trouve ainsi canalisé dans le tronçon de dégagement et l'on évite la formation d'une bavure en direction de la piste conductrice adjacente.

L'invention est définie dans les revendications.

D'autres caractéristiques et avantages de l'invention apparaîtront à la lecture de la description qui suit d'un mode de réalisation préféré non limitatif de l'invention, en référence aux figures parmi lesquelles:
- la figure 1 est une vue au microscope de deux tronçons de piste conductrice obtenus lorsque les lignes de réserve de l'écran de sérigraphie s'étendent perpendiculairement à la direction de déplacement de la râcle.
- la figure 2 est une représentation agrandie d'un dessin de pistes conductrice selon l'invention.

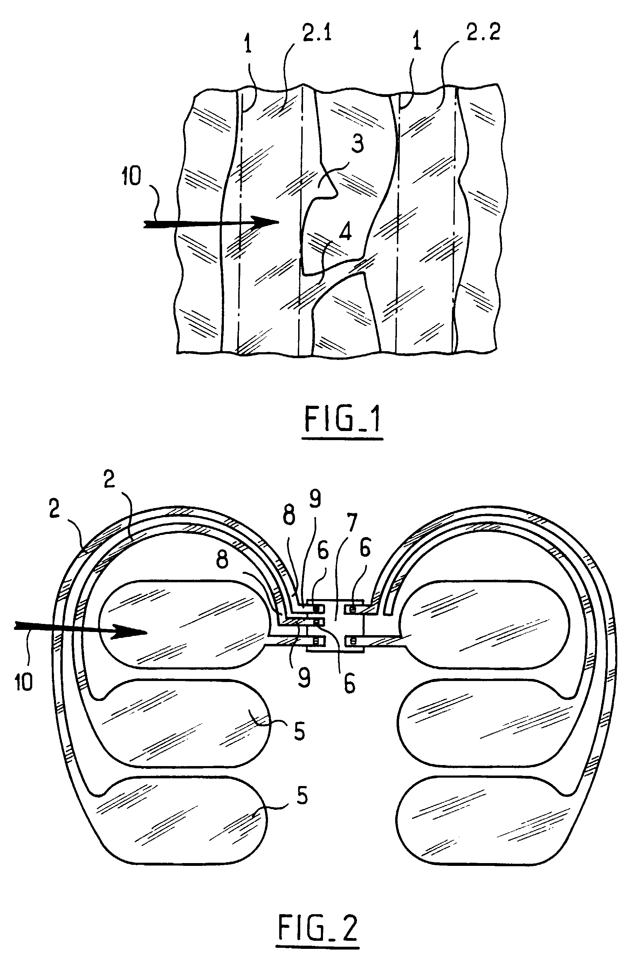

On a représenté en traits mixtes sur la figure 1 le contour 1 de deux lignes de réserve adjacentes d'un écran de sérigraphie et par une flèche en trait épais 10 la direction de déplacement de la râcle. On constate que les pistes conductrices 2.1 et 2.2 obtenues comportent des bords (représentés en trait continu) sinueux formant des bavures 3, 4 qui s'étendent vers la piste conductrice adjacente. Dans le cas illustré, la bavure 4 a une amplitude telle qu'elle atteint la piste conductrice adjacente 2.2 et forme ainsi un court-circuit entre les pistes conductrices 2.1 et 2.2.

La figure 2 illustre un exemple de dessin de pistes conductrices selon l'invention. Ainsi qu'il apparaît sur la figure 2, les pistes conductrices 2 qui relient les plages conductrices 5 aux plots 6 du circuit intégré 7 ont un contour curviligne formant par rapport à la direction de déplacement de la râcle, ou direction de référence, figurée à nouveau par une flèche en trait épais 10, un angle différent de 90° sur sensiblement la totalité du contour.

Pour des raisons d'encombrement lié à l'espacement entre les plots 6 du circuit intégré, deux pistes conductrices comportent cependant un segment de piste 8 qui est sensiblement perpendiculaire à la direction de référence. Selon un aspect avantageux de l'invention le segment de piste 8 comporte alors un tronçon de dégagement 9 prolongeant le segment de piste 8 selon une direction sensiblement identique à la direction de référence. Dans le mode de réalisation illustré, les tronçons de dégagement 9 font partie intégrante des pistes conductrices 2 et assurent la liaison avec les plots 6 du circuit intégré. On remarquera à ce propos que l'espacement des plots 6 du circuit intégré 7 selon la direction de référence est sensiblement plus important que l'espacement entre deux pistes conductrices adjacentes 2 de sorte que si une bavure se forme à l'extrémité du tronçon de dégagement dans la direction de déplacement de la râcle, cette bavure sera en tout état de cause d'une amplitude inférieure à la distance qui sépare deux plots 6 en regard et ne risquera donc pas de réaliser un court-circuit.

Bien entendu l'invention n'est pas limitée au mode de réalisation décrit et on peut y apporter des variantes de réalisation sans sortir du cadre de l'invention laquelle est définie dans les revendications.

Bien que l'invention ait été illustrée en mentionnant une seule direction de référence, les pistes conductrices selon l'invention peuvent être associées à plusieurs directions de référence possibles. Dans l'exemple illustré sur la figure 2 il existe en particulier une infinité de directions de références possibles.

## Revendications

1. Carte à circuit intégré comportant des pistes conductrices (2) en polymère conducteur reliant le circuit intégré (7) à des plages de contact (5), caractérisée en ce que les pistes conductrices (2) ont un contour curviligne.

2. Carte selon la revendication 1, caractérisée en ce que les pistes conductrices comportent au moins un tronçon de dégagement (9) s'étendant perpendiculairement à un segment de piste (8).

## Patentansprüche

1. IC-Karte mit Leiterbahnen (2) aus leitfähigem Polymer, die den integrierten Schaltkreis (7) mit Kontaktflächen (5) verbinden, dadurch **gekennzeichnet**, daß die Leiterbahnen (2) eine kurvilineare Kontur aufweisen.

2. Karte nach Anspruch 1, dadurch **gekennzeichnet**, daß die Leiterbahnen zumindest einen Nutabschnitt (9) umfassen, der sich senkrecht zu einem Bahnsegment (8) erstreckt.

## Claims

1. An integrated circuit card having conductive polymer conductor tracks (2) connecting the integrated circuit (7) to contact areas (5), the card being characterized in that the conductor tracks (2) follow curvilinear paths.

2. A card according to claim 1, characterized in that the conductor tracks have at least one escape length (9) extending perpendicularly to a track segment (8).
